# EUROPEAN PATENT APPLICATION

(11) **EP 4 510 545 A1**
(43) Date of publication of application: **19.02.2025**
(21) Application number: 23807779.6
(22) Date of filing: 04.04.2023
(51) Int. Cl.: H04M 1/02

(54) **METAL PLATE HAVING LATTICE PATTERN, AND ELECTRONIC DEVICE COMPRISING SAME**

(30) Priority: 19.05.2022 KR 20220061453; 23.08.2022 KR 20220105662
(71) Applicant: Samsung Electronics Co., Ltd., Suwon-si, Gyeonggi-do 16677 (KR)
(72) Inventor: LEE, Hosoon, Suwon-si Gyeonggi-do 16677 (KR); LEE, Wonsun, Suwon-si Gyeonggi-do 16677 (KR); KIM, Taejeong, Suwon-si Gyeonggi-do 16677 (KR)
(74) Representative: Gulde & Partner
(86) International application number: PCT/KR2023/004487
(87) International publication number: WO 2023/224256

(57) **Abstract**

An electronic device according to one embodiment comprises: a display; glass covering the display; and a metal plate which is provided on the side opposite to the glass with respect to the display, and which supports the display, wherein the metal plate comprises: a plurality of slits penetrating the metal plate; a plurality of main bridges which are defined by the plurality of slits and of which the lengthwise direction is formed as a first direction; and a plurality of connection bridges which are defined by the plurality of slits, which are connected to the plurality of main bridges, of which the lengthwise direction is formed as a second direction crossing the first direction, and which are thinner than a metal plate body.

## Description

### TECHNICAL FIELD

An embodiment of the present disclosure relates to a metal plate having a lattice pattern and an electronic device including the same.

### BACKGROUND ART

An electronic device is gradually becoming slimmer, and improvements are being made to increase the rigidity, strengthen design aspects, and differentiate functional elements of an electronic device. An electronic device is being transformed from a uniform rectangular shape into various shapes. A display may have a deformable structure.

### DISCLOSURE OF THE INVENTION

### TECHNICAL SOLUTIONS

According to an embodiment, an electronic device includes a display, glass configured to cover the display, and a metal plate provided on an opposite side of the glass with respect to the display and configured to support the display, in which the metal plate includes a plurality of slits formed through the metal plate, a plurality of main bridges defined by the plurality of slits and of which a longitudinal direction is formed in a first direction, and a plurality of connection bridges defined by the plurality of slits, connected to the plurality of main bridges, of which a longitudinal direction is formed in a second direction crossing the first direction, and having a thickness that is thinner than a metal plate body.

According to an embodiment, a metal plate having a lattice pattern includes a metal plate body, a plurality of slits formed through the metal plate, a plurality of main bridges defined by the plurality of slits and of which a longitudinal direction is formed in a first direction, and a plurality of connection bridges defined by the plurality of slits, connected to the plurality of main bridges, of which a longitudinal direction is formed in a second direction crossing the first direction, and having a thickness that is thinner than the metal plate body.

According to an embodiment, an electronic device includes a display, glass configured to cover the display, a metal plate provided on an opposite side of the glass with respect to the display and configured to support the display, in which the metal plate includes a plurality of slits formed through the metal plate, a plurality of main bridges defined by the plurality of slits and of which a longitudinal direction is formed in a first direction, and a plurality of connection bridges defined by the plurality of slits, connected to the plurality of main bridges, and of which a longitudinal direction is formed in a second direction crossing the first direction, and a plurality of multi-bars attached to the metal plate, in which the connection bridges include a portion of which a thickness changes along the second direction.

### BRIEF DESCRIPTION OF DRAWINGS

FIG. 1 is a block diagram illustrating an electronic device in a network environment, according to an embodiment.
FIG. 2A is a diagram illustrating an electronic device in an unfolded state, according to an embodiment.
FIG. 2B is a diagram illustrating an electronic device in a folded state, according to an embodiment.
FIG. 3A is a perspective view illustrating an electronic device in a first state, according to an embodiment.
FIG. 3B is a perspective view illustrating an electronic device in a second state, according to an embodiment.
FIG. 3C is a rear perspective view illustrating an electronic device in a first state, according to an embodiment.
FIG. 3D is a rear perspective view illustrating an electronic device in a second state, according to an embodiment.
FIG. 4 is a cross-sectional view illustrating an electronic device according to an embodiment.
FIG. 5 is a side view schematically illustrating a foldable electronic device according to an embodiment.
FIG. 6 is a side view schematically illustrating a rollable electronic device according to an embodiment.
FIG. 7 is a side view schematically illustrating a rollable electronic device according to an embodiment.
FIG. 8 is a bottom view illustrating a metal plate according to an embodiment.
FIG. 9 is a bottom view illustrating a state in which a multi-bar is removed from a metal plate, according to an embodiment.
FIG. 10 is an enlarged bottom view illustrating a portion of a metal plate, according to an embodiment.
FIG. 11A is a cross-sectional view taken along the line A-A of FIG. 10.
FIG. 11B is a cross-sectional view taken along the line B-B of FIG. 10.
FIG. 11C is a cross-sectional view taken along the line C-C of FIG. 10.
FIG. 11D is a cross-sectional view taken along the line D-D of FIG. 10.
FIG. 12 is an enlarged bottom view illustrating a portion of a metal plate, according to an embodiment.
FIG. 13A is a cross-sectional view taken along the line E-E of FIG. 12.
FIG. 13B is a cross-sectional view taken along the line F-F of FIG. 12.
FIG. 13C is a cross-sectional view taken along the line G-G of FIG. 12.
FIG. 13D is a cross-sectional view taken along the line H-H of FIG. 12.

### BEST MODE FOR CARRYING OUT THE INVENTION

Hereinafter, embodiments will be described in detail with reference to the accompanying drawings. When describing the embodiments with reference to the accompanying drawings, like reference numerals refer to like elements and a repeated description related thereto will be omitted.

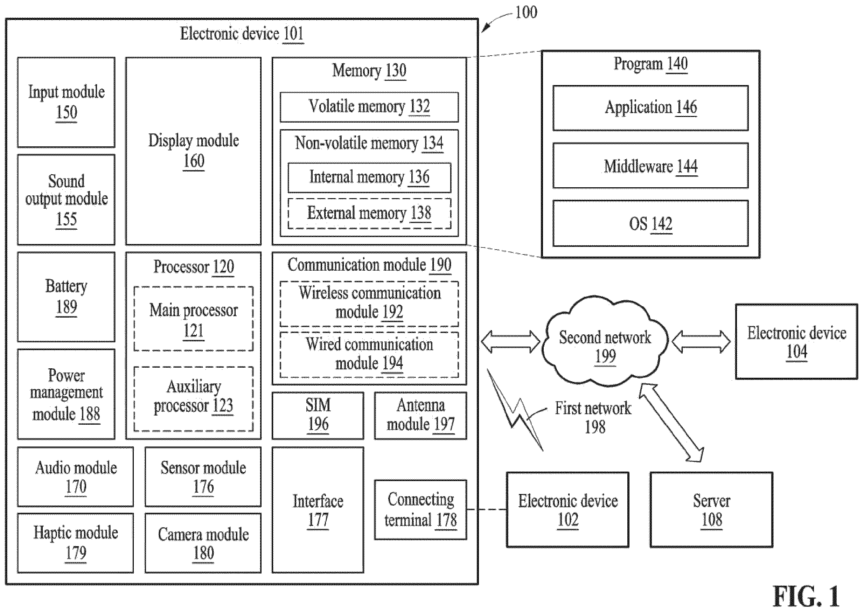

FIG. 1 is a block diagram illustrating an electronic device 101 in a network environment 100, according to an embodiment. Referring to FIG. 1, the electronic device 101 in the network environment 100 may communicate with an electronic device 102 via a first network 198 (e.g., a short-range wireless communication network) or communicate with at least one of an electronic device 104 and a server 108 via a second network 199 (e.g., a long-range wireless communication network). According to an embodiment, the electronic device 101 may communicate with the electronic device 104 via the server 108. According to an embodiment, the electronic device 101 may include a processor 120, a memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In some embodiments, at least one of the components (e.g., the connecting terminal 178) may be omitted from the electronic device 101, or one or more other components may be added to the electronic device 101. In some embodiments, some of the components (e.g., the sensor module 176, the camera module 180, or the antenna module 197) may be integrated as a single component (e.g., the display module 160).

The processor 120 may execute, for example, software (e.g., a program 140) to control at least one other component (e.g., a hardware or software component) of the electronic device 101 connected to the processor 120 and may perform various data processing or computations. According to an embodiment, as at least a part of data processing or computations, the processor 120 may store a command or data received from another component (e.g., the sensor module 176 or the communication module 190) in a volatile memory 132, process the command or the data stored in the volatile memory 132, and store resulting data in a non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from or in conjunction with the main processor 121. For example, when the electronic device 101 includes the main processor 121 and the auxiliary processor 123, the auxiliary processor 123 may be adapted to consume less power than the main processor 121 or to be specific to a specified function. The auxiliary processor 123 may be implemented separately from the main processor 121 or as a part of the main processor 121.

The auxiliary processor 123 may control at least some of functions or states related to at least one (e.g., the display module 160, the sensor module 176, or the communication module 190) of the components of the electronic device 101, instead of the main processor 121 while the main processor 121 is in an inactive (e.g., sleep) state or along with the main processor 121 while the main processor 121 is an active state (e.g., executing an application). According to an embodiment, the auxiliary processor 123 (e.g., an ISP or a CP) may be implemented as a portion of another component (e.g., the camera module 180 or the communication module 190) that is functionally related to the auxiliary processor 123. According to an embodiment, the auxiliary processor 123 (e.g., an NPU) may include a hardware structure specifically for artificial intelligence model processing. An artificial intelligence model may be generated by machine learning. The machine learning may be performed by, for example, the electronic device 101, in which artificial intelligence is performed, or performed via a separate server (e.g., the server 108). Learning algorithms may include, but are not limited to, for example, supervised learning, unsupervised learning, semi-supervised learning, or reinforcement learning. The artificial intelligence (AI) model may include a plurality of artificial neural network layers. An artificial neural network may include, for example, a deep neural network (DNN), a convolutional neural network (CNN), a recurrent neural network (RNN), a restricted Boltzmann machine (RBM), a deep belief network (DBN), and a bidirectional recurrent deep neural network (BRDNN), a deep Q-network, or a combination of two or more thereof, but is not limited thereto. The AI model may additionally or alternatively include a software structure other than the hardware structure.

The memory 130 may store various pieces of data used by at least one component (e.g., the processor 120 or the sensor module 176) of the electronic device 101. The various pieces of data may include, for example, software (e.g., the program 140) and input data or output data for a command related thereto. The memory 130 may include the volatile memory 132 or the non-volatile memory 134.

The program 140 may be stored as software in the memory 130 and may include, for example, an operating system (OS) 142, middleware 144, or an application 146.

The input module 150 may receive, from outside (e.g., a user) the electronic device 101, a command or data to be used by another component (e.g., the processor 120) of the electronic device 101. The input module 150 may include, for example, a microphone, a mouse, a keyboard, a key (e.g., a button), or a digital pen (e.g., a stylus pen).

The sound output module 155 may output a sound signal to the outside of the electronic device 101. The sound output module 155 may include, for example, a speaker or a receiver. The speaker may be used for general purposes, such as playing multimedia or playing a recording. The receiver may be used to receive an incoming call. According to an embodiment, the receiver may be implemented separately from the speaker or as a part of the speaker.

The display module 160 may visually provide information to the outside (e.g., a user) of the electronic device 101. The display module 160 may include, for example, a control circuit for controlling a display, a hologram device, or a projector and control circuitry to control its corresponding one of the display, the hologram device, and the projector. According to an embodiment, the display module 160 may include a touch sensor adapted to detect a touch, or a pressure sensor adapted to measure the intensity of force of the touch.

The audio module 170 may convert sound into an electric signal or vice versa. According to an embodiment, the audio module 170 may obtain the sound via the input module 150 or output the sound via the sound output module 155 or an external electronic device (e.g., the electronic device 102, such as a speaker or headphones) directly or wirelessly connected to the electronic device 101.

The sensor module 176 may detect an operational state (e.g., power or temperature) of the electronic device 101 or an environmental state (e.g., a state of a user) external to the electronic device 101 and generate an electric signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used by the electronic device 101 to couple with the external electronic device (e.g., the electronic device 102) directly (e.g., by wire) or wirelessly. According to an embodiment, the interface 177 may include, for example, a high-definition multimedia interface (HDMI), a universal serial bus (USB) interface, a secure digital (SD) card interface, or an audio interface.

The connecting terminal 178 may include a connector via which the electronic device 101 may physically connect to an external electronic device (e.g., the electronic device 102). According to an embodiment, the connecting terminal 178 may include, for example, an HDMI connector, a USB connector, an SD card connector, or an audio connector (e.g., a headphones connector).

The haptic module 179 may convert an electric signal into a mechanical stimulus (e.g., a vibration or a movement) or an electrical stimulus, which may be recognized by a user via their tactile sensation or kinesthetic sensation. According to an embodiment, the haptic module 179 may include, for example, a motor, a piezoelectric element, or an electric stimulator.

The camera module 180 may capture a still image and moving images. According to an embodiment, the camera module 180 may include one or more lenses, image sensors, ISPs, and flashes.

The power management module 188 may manage power supplied to the electronic device 101. According to an embodiment, the power management module 188 may be implemented as, for example, at least a part of a power management integrated circuit (PMIC).

The battery 189 may supply power to at least one component of the electronic device 101. According to an embodiment, the battery 189 may include, for example, a primary cell, which is not rechargeable, a secondary cell, which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more CPs that are operable independently from the processor 120 (e.g., an AP) and that support direct (e.g., wired) communication or wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module, or a power line communication (PLC) module). A corresponding one of these communication modules may communicate with the external electronic device, for example, the electronic device 104, via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., a LAN or a wide area network (WAN)). These various types of communication modules may be implemented as a single component (e.g., a single chip), or may be implemented as multiple components (e.g., multiple chips) separate from each other. The wireless communication module 192 may identify and authenticate the electronic device 101 in a communication network, such as the first network 198 or the second network 199, using subscriber information (e.g., international mobile subscriber identity (IMSI)) stored in the SIM 196.

The wireless communication module 192 may support a 5G network after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., a mmWave band) to achieve, e.g., a high data transmission rate. The wireless communication module 192 may support various technologies for securing performance on a high-frequency band, such as, e.g., beamforming, massive multiple-input and multiple-output (MIMO), full dimensional MIMO (FD-MIMO), an array antenna, analog beam-forming, or a large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20 Gbps or more) for implementing eMBB, loss coverage (e.g., 164 dB or less) for implementing mMTC, or U-plane latency (e.g., 0.5 ms or less for each of downlink (DL) and uplink (UL), or a round trip of 1 ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element including a conductive material or a conductive pattern formed in or on a substrate (e.g., a printed circuit board (PCB)). According to an embodiment, the antenna module 197 may include a plurality of antennas (e.g., an antenna array). In such a case, at least one antenna appropriate for a communication scheme used in a communication network, such as the first network 198 or the second network 199, may be selected by, for example, the communication module 190 from the plurality of antennas. The signal or power may be transmitted or received between the communication module 190 and the external electronic device via the at least one selected antenna. According to an embodiment, another component (e.g., a radio frequency integrated circuit (RFIC)) other than the radiating element may be additionally formed as a part of the antenna module 197.

According to various embodiments, the antenna module 197 may form a mmWave antenna module. According to an embodiment, the mm Wave antenna module may include a PCB, an RFIC on a first surface (e.g., the bottom surface) of the PCB, or adjacent to the first surface of the PCB and capable of supporting a designated high-frequency band (e.g., a mmWave band), and a plurality of antennas (e.g., array antennas) disposed on a second surface (e.g., the top or a side surface) of the PCB, or adjacent to the second surface of the PCB and capable of transmitting or receiving signals of the designated high-frequency band.

At least some of the above-described components may be coupled mutually and exchange signals (e.g., commands or data) therebetween via an inter-peripheral communication scheme (e.g., a bus, general purpose input and output (GPIO), serial peripheral interface (SPI), or mobile industry processor interface (MIPI).

According to an embodiment, commands or data may be transmitted or received between the electronic device 101 and the external electronic device (e.g., the electronic device 104) via the server 108 coupled with the second network 199. Each of the external electronic devices (e.g., the electronic device 102 or 104) may be a device of the same type as or a different type from the electronic device 101. According to an embodiment, all or some of operations to be executed by the electronic device 101 may be executed by one or more external electronic devices (e.g., the electronic devices 102 and 104 and the server 108). For example, if the electronic device 101 needs to perform a function or a service automatically, or in response to a request from a user or another device, the electronic device 101, instead of, or in addition to, executing the function or the service, may request the one or more external electronic devices to perform at least part of the function or service. The one or more external electronic devices receiving the request may perform the at least part of the function or service, or an additional function or an additional service related to the request and may transfer a result of the performance to the electronic device 101. The electronic device 101 may provide the result, with or without further processing the result, as at least part of a response to the request. To that end, cloud computing, distributed computing, mobile edge computing (MEC), or client-server computing technology may be used, for example. The electronic device 101 may provide ultra low-latency services using, e.g., distributed computing or MEC. In an embodiment, the external electronic device (e.g., the electronic device 104) may include an Internet-of-things (IoT) device. The server 108 may be an intelligent server using machine learning and/or a neural network. According to an embodiment, the external electronic device (e.g., the electronic device 104) or the server 108 may be included in the second network 199. The electronic device 101 may be applied to intelligent services (e.g., a smart home, a smart city, a smart car, or healthcare) based on 5G communication technology or IoT-related technology.

The electronic device according to various embodiments may be one of various types of electronic devices. The electronic device may include, for example, a portable communication device (e.g., a smartphone), a computer device, a portable multimedia device, a portable medical device, a camera, a wearable device, or a home appliance device. According to an embodiment of the disclosure, the electronic device is not limited to those described above.

It should be understood that various embodiments of the present disclosure and the terms used therein are not intended to limit the technological features set forth herein to particular embodiments and include various changes, equivalents, or replacements for a corresponding embodiment. In connection with the description of the drawings, like reference numerals may be used for similar or related components. It is to be understood that a singular form of a noun corresponding to an item may include one or more of the things unless the relevant context clearly indicates otherwise. As used herein, "A or B", "at least one of A and B", "at least one of A or B", "A, B or C", "at least one of A, B and C", and "A, B, or C," each of which may include any one of the items listed together in the corresponding one of the phrases, or all possible combinations thereof. Terms such as "first", "second", or "first" or "second" may simply be used to distinguish the component from other components in question, and do not limit the components in other aspects (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., by wire), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., the internal memory 136 or the external memory 138) that is readable by a machine (e.g., the electronic device 101). For example, a processor (e.g., the processor 120) of the machine (e.g., the electronic device 101) may invoke at least one of the one or more instructions stored in the storage medium and execute it. This allows the machine to be operated to perform at least one function according to the at least one instruction invoked. The one or more instructions may include code generated by a compiler or code executable by an interpreter. The machine-readable storage medium may be provided in the form of a non-transitory storage medium. Here, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., a compact disc read-only memory (CD-ROM)), or be distributed (e.g., downloaded or uploaded) online via an application store (e.g., PlayStore^{™}), or between two user devices (e.g., smartphones) directly. If distributed online, at least part of the computer program product may be temporarily generated or at least temporarily stored in the machine-readable storage medium, such as a memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

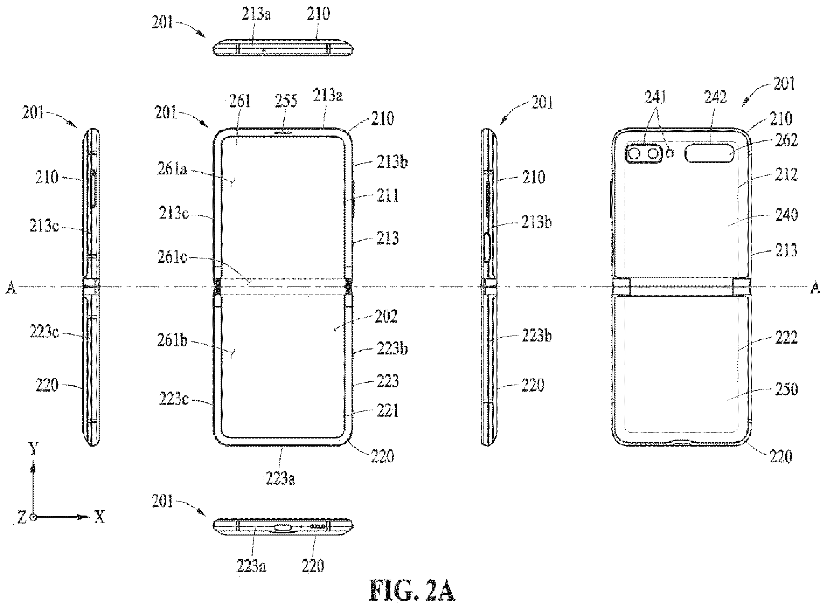

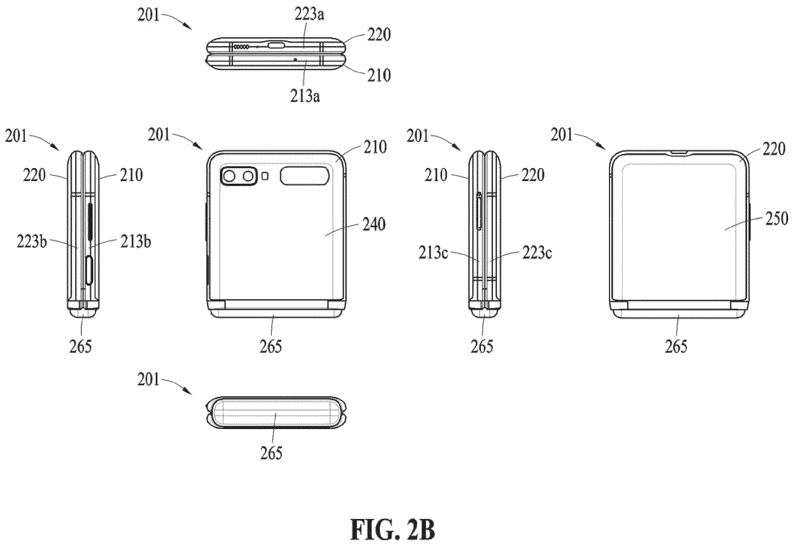

FIG. 2A is a diagram illustrating an electronic device in an unfolded state, according to an embodiment, and FIG. 2B is a diagram illustrating an electronic device in a folded state, according to an embodiment.

Referring to FIGS. 2A and 2B, a foldable electronic device 201 according to an embodiment may include a pair of housings 210 and 220 rotatably coupled to each other through a hinge structure to be folded with respect to each other, a hinge cover 265 for covering foldable portions of the pair of housings 210 and 220, and a display 261 (e.g., a flexible display or a foldable display) disposed in a space formed by the pair of housings 210 and 220. In the present disclosure, a surface on which the display 261 is disposed may be defined as a front surface of the foldable electronic device 201, and a surface that is opposite to the front surface may be defined as a rear surface of the foldable electronic device 201. In addition, a surface enclosing a space between the front surface and the rear surface may be defined as a side surface of the foldable electronic device 201.

In an embodiment, the pair of housings 210 and 220 may include a first housing 210, a second housing 220, a first rear cover 240, and a second rear cover 250. The pair of housings 210 and 220 of the electronic device 201 are not limited to the shape or combination and/or coupling of components shown in FIGS. 2A and 2B and may be implemented in other shapes or by another combination and/or coupling of components.

In an embodiment, the first housing 210 and the second housing 220 may be disposed on both sides (e.g., an upper portion and a lower portion) with respect to a folding axis A and may be disposed substantially symmetrical with respect to the folding axis A. In an embodiment, an angle or distance between the first housing 210 and the second housing 220 may vary depending on whether the electronic device 201 is in an unfolded state, a folded state, or an intermediate state.

In an embodiment, the first housing 210 may be connected to a hinge structure in the unfolded state of the electronic device 201. The first housing 210 may include a first surface 211 facing the front surface of the electronic device 201, a second surface 212 facing a direction that is opposite to the first surface 211, and a first side portion 213 enclosing at least a portion of a space between the first surface 211 and the second surface 212. The first side portion 213 may include a first side surface 213a disposed substantially in parallel with the folding axis A, a second side surface 213b extending in a direction that is substantially perpendicular to the folding axis A from one end portion of the first side surface 213a, and a third side surface 213c extending in a direction that is substantially perpendicular to the folding axis A from the other end portion of the first side surface 213a and substantially parallel to the second side surface 213b. The second housing 220 may be connected to the hinge structure in the unfolded state of the electronic device 201. The second housing 220 may include a third surface 221 facing the front surface of the electronic device 201, a fourth surface 222 facing a direction that is opposite to the third surface 221, and a second side portion 223 enclosing at least a portion of a space between the third surface 221 and the fourth surface 222. The second side portion 223 may include a fourth side surface 223a disposed substantially in parallel with the folding axis A, a fifth side surface 223b extending in a direction that is substantially perpendicular to the folding axis A from one end portion of the fourth side surface 223a, and a sixth side surface 223c extending in a direction that is substantially perpendicular to the folding axis A from the other end portion of the fourth side surface 223a and substantially parallel to the fifth side surface 223b. The first surface 211 and the third surface 221 may face each other when the electronic device 201 is in the folded state.

In an embodiment, the electronic device 201 may include an accommodating portion 202 in a recessed shape that accommodates the display 261 through the structural coupling of the first housing 210 and the second housing 220. The accommodating portion 202 may have substantially the same size as the display 261.

In an embodiment, at least a portion of the first housing 210 and the second housing 220 may be formed of a metal material or non-metal material having a predetermined magnitude of rigidity that is appropriate to support the display 261.

In an embodiment, the electronic device 201 may include at least one component disposed to be visually exposed on the front surface of the electronic device 201 to perform various functions. For example, the component may include at least one of a front camera module, a receiver, a proximity sensor, an illuminance sensor, an iris recognition sensor, an ultrasonic sensor, or an indicator. In an embodiment, the component included in the electronic device 201 may be disposed not to be visually exposed to the outside of the electronic device 201. For example, the at least one component may be disposed on a rear surface of the display 261.

In an embodiment, the electronic device 201 may include a sound output module 255 (e.g., the sound output module 155) disposed through at least a partial area of the first surface 211.

In an embodiment, the first rear cover 240 may be disposed on the second surface 212 of the first housing 210 and may have substantially rectangular peripheries. At least a portion of the peripheries of the first rear cover 240 may be enclosed by the first housing 210. The second rear cover 250 may be disposed on the fourth surface 222 of the second housing 220 and may have substantially rectangular peripheries. At least a portion of the peripheries of the second rear cover 250 may be enclosed by the second housing 220.

In an embodiment, the first rear cover 240 and the second rear cover 250 may have substantially symmetrical shapes with respect to the folding axis A. In another embodiment, the first rear cover 240 and the second rear cover 250 may have different shapes. In still another embodiment, the first housing 210 and the first rear cover 240 may be integrally formed, and the second housing 220 and the second rear cover 250 may be integrally formed.

In an embodiment, the first housing 210, the second housing 220, the first rear cover 240, and the second rear cover 250 may provide a space in which various components (e.g., a PCB, the antenna module 197, the sensor module 176, or the battery 189) of the electronic device 201 may be disposed through a structure in which the first housing 210, the second housing 220, the first rear cover 240, and the second rear cover 250 are coupled to one another. In an embodiment, at least one component may be visually exposed on the rear surface of the electronic device 201. For example, at least one component may be visually exposed through a first rear area 241 of the first rear cover 240. Here, the component may include a proximity sensor, a rear camera module, and/or a flash. In an embodiment, at least a portion of a sub-display 262 may be visually exposed through a second rear area 242 of the first rear cover 240.

In an embodiment, the display 261 may be disposed in the accommodating portion 202 formed by the pair of housings 210 and 220. For example, the display 261 may be disposed to occupy substantially most of the front surface of the electronic device 201. The front surface of the electronic device 201 may include an area on which the display 261 is disposed, and a partial area (e.g., a periphery area) of the first housing 210 and a partial area (e.g., a periphery area) of the second housing 220, which are adjacent to the display 261. The rear surface of the electronic device 201 may include the first rear cover 240, a partial area (e.g., a periphery area) of the first housing 210 that is adjacent to the first rear cover 240, the second rear cover 250, and a partial area (e.g., a periphery area) of the second housing 220 that is adjacent to the second rear cover 250. In an embodiment, the display 261 may be a display in which at least one area is deformable into a planar surface or curved surface. In an embodiment, the display 261 may include a folding area 261c, a first area 261a on a first side (e.g., an upper portion) of the folding area 261c, and a second area 261b on a second side (e.g., a lower portion) of the folding area 261c. The first area 261a may be positioned on the first surface 211 of the first housing 210, and the second area 261b may be positioned on the third surface 221 of the second housing 220. However, the area division of the display 261 is only an example, and the display 261 may be divided into a plurality of areas depending on the structure or function of the display 261. For example, as shown in FIG. 2A, the display 261 may be divided into areas based on the folding axis A or the folding area 261c extending in parallel to an X-axis, or the display 261 may be divided into areas based on another folding axis (e.g., a folding axis that is parallel to a Y-axis) or another folding area (e.g., a folding area extending in parallel to the Y-axis). The area division of the display 261 as above is simply physical division based on the pair of housings 210 and 220 and the hinge structure, and the display 261 may display substantially one screen through the pair of housings 210 and 220 and the hinge structure. In an embodiment, the first area 261a and the second area 261b may have substantially symmetrical shapes with respect to the folding area 261c.

In an embodiment, the hinge cover 265 may be disposed between the first housing 210 and the second housing 220 and configured to cover the hinge structure. The hinge cover 265 may be hidden by at least a portion of the first housing 210 and the second housing 220 or exposed to the outside according to the operational state of the electronic device 201. For example, when the electronic device 201 is in an unfolded state as shown in FIG. 2A, the hinge cover 265 may be hidden by the first housing 210 and the second housing 220 and not be exposed to the outside, and when the electronic device 201 is in a folded state as shown in FIG. 2B, the hinge cover 265 may be exposed to the outside between the first housing 210 and the second housing 220. Moreover, when the electronic device 201 is in the intermediate state in which the first housing 210 and the second housing 220 form an angle with each other, at least a portion of the hinge cover 265 may be exposed to the outside between the first housing 210 and the second housing 220. In this case, the area of the hinge cover 265 exposed to the outside may be smaller than the area of the hinge cover 265 exposed when the electronic device 201 is in the folded state. In an embodiment, the hinge cover 265 may have a curved surface.

Describing the operation of the electronic device 201, when the electronic device 201 is in an unfolded state (e.g., the state of the electronic device 201 of FIG. 2A), the first housing 210 and the second housing 220 may form a first angle (e.g., about 180 degrees) with each other, and the first area 261a and the second area 261b of the display 261 may be oriented in substantially the same direction. The folding area 261c of the display 261 may be on substantially the same plane as the first area 261a and the second area 261b. In another embodiment, when the electronic device 201 is in the unfolded state, the first housing 210 may rotate relative to the second housing 220 at a second angle (e.g., about 360 degrees), whereby the first housing 210 and the second housing 220 may be reversely folded such that the second surface 212 and the fourth surface 222 may face each other. Moreover, when the electronic device 201 is in the folded state (e.g., the state of the electronic device 201 of FIG. 2B), the first housing 210 and the second housing 220 may face each other. The first housing 210 and the second housing 220 may form an angle of about 0 degrees to about 10 degrees, and the first area 261a and the second area 261b of the display 261 may face each other. At least a portion of the folding area 261c of the display 261 may be deformed into a curved surface. Moreover, when the electronic device 201 is in the intermediate state, the first housing 210 and the second housing 220 may form a predetermined angle with each other. An angle (e.g., a third angle, about 90 degrees) formed by the first area 261a and the second area 261b of the display 261 may be greater than that when the electronic device 201 is in the folded state and less than that when the electronic device 201 is in the unfolded state. At least a portion of the folding area 261c of the display 261 may be deformed into a curved surface. In this case, a curvature of the curved surface of the folding area 261c may be smaller than that when the electronic device 201 is in the folded state.

In an embodiment, the electronic device 201 may be folded about the folding axis A by means of a hinge structure. For example, it is shown in the drawings that the folding axis A is formed by the hinge structure in a horizontal direction (e.g., the X-axis direction) of the electronic device 201 for ease of description, but this is only an example, and the direction in which the folding axis A is formed is not limited thereto. For example, the folding axis A formed by the hinge structure may be formed in a vertical direction (e.g., the Y-axis direction) of the electronic device 201, or a plurality of folding axes may all be formed in the same direction or in different directions such that the electronic device 201 may be folded a plurality of times through the plurality of folding axes. Moreover, an embodiment of an electronic device described herein is not limited to a form factor of the electronic device 201 described with reference to FIGS. 2A and 2B and may also apply to an electronic device with various form factors.

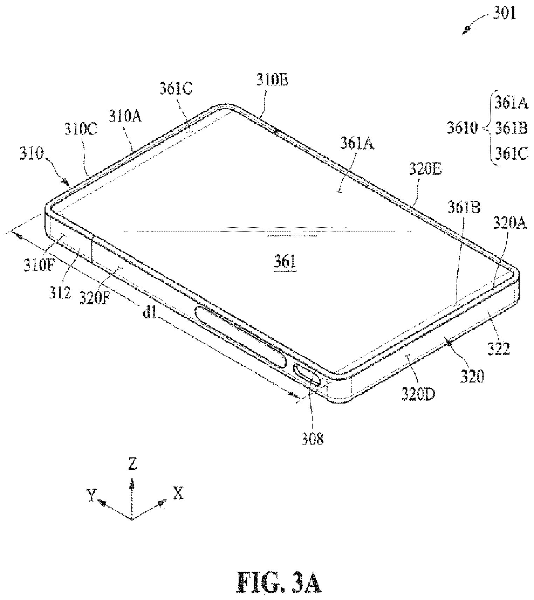

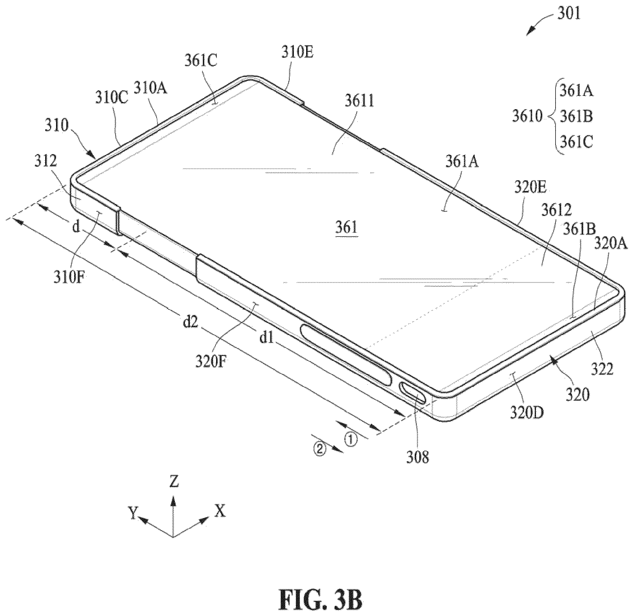

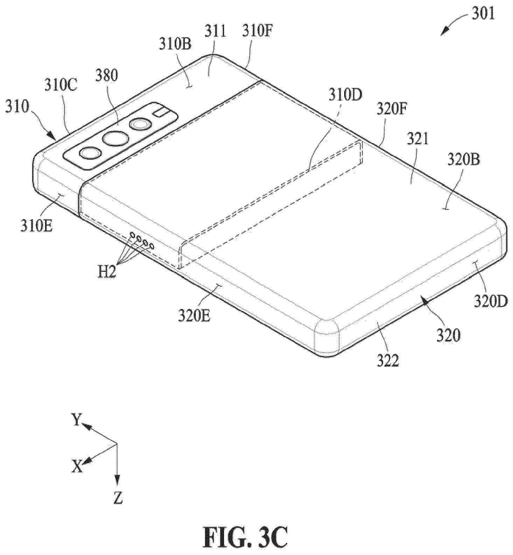

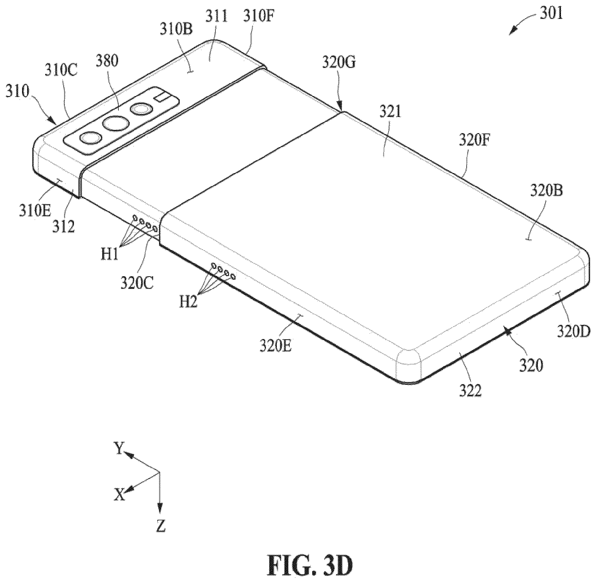

FIG. 3A is a perspective view illustrating an electronic device in a first state, according to an embodiment. FIG. 3B is a perspective view illustrating an electronic device in a second state, according to an embodiment. FIG. 3C is a rear perspective view illustrating an electronic device in a first state, according to an embodiment. FIG. 3D is a rear perspective view illustrating an electronic device in a second state, according to an embodiment.

Referring to FIGS. 3A to 3D, an electronic device 301 according to an embodiment may include housings 310 and 320 that form an exterior and accommodate components inside. In an embodiment, the housings 310 and 320 may include a first housing 310 and a second housing 320 that are movably coupled to each other. In an embodiment, the first housing 310 may be slidably connected to the second housing 320. For example, the first housing 310 may move relative to the second housing 320 in a first moving direction (direction ①) (e.g., a +Y direction) or may be movably connected to the second housing 320 in a second moving direction (direction ②) (e.g., a -Y direction) that is opposite to the first moving direction (direction ①). Hereinafter, in an embodiment provided herein, the first housing 310 is described as moving relative to the second housing 320, but this is for the description of the relative movement of the first housing 310 and the second housing 320 with respect to each other. Thus, it could also be understood that the second housing 320 moves relative to the first housing 310.

In an embodiment, according to the relative movement of the first housing 310 to the second housing 320, a state of the electronic device 301 may change between the first state and the second state. In an embodiment, the electronic device 301 may have a reduced shape in the first state and an extended shape in the second state. The electronic device 301 may be used in the first state or the second state or may be used in an intermediate state between the first state and the second state.

In an embodiment, the first housing 310 may include a first surface 310A (e.g., a first front surface), a second surface 310B (e.g., a first rear surface) that is opposite to the first surface 310A, a first side surface 310C facing a first lateral direction (e.g., a +Y direction) and disposed between the first surface 310A and the second surface 310B, a second side surface 310D facing a second lateral direction (e.g., a -Y direction) that is opposite to the first lateral direction and disposed between the first surface 310A and the second surface 310B, a third side surface 310E facing a third lateral direction (e.g., an + X direction) crossing the first lateral direction and disposed between the first surface 310A and the second surface 310B, and a fourth side surface 310F facing a fourth lateral direction (e.g., an -X direction) that is opposite to the third lateral direction and disposed between the first surface 310A and the second surface 310B. In an embodiment, the first housing 310 may include a first plate 311 and a first side frame 312 that substantially extends in a thickness direction (e.g., a z-axis direction) along an edge of the first plate 311. In an embodiment, the first plate 311 may form the second surface 310B, and the first side frame 312 may form the first side surface 310C, the second side surface 310D, the third side surface 310E, and the fourth side surface 310F. In an embodiment, the first plate 311 and the first side frame 312 may be integrally formed or may be separately formed to be coupled to each other.

In an embodiment, the second housing 320 may include a third surface 320A (e.g., a second front surface), a fourth surface 320B (e.g., a second rear surface) that is opposite to the third surface 320A, a fifth side surface 320C facing the first lateral direction (e.g., the +Y direction) and disposed between the third surface 320A and the fourth surface 320B, a sixth side surface 320D facing the second lateral direction (e.g., the -Y direction) that is opposite to the first lateral direction and disposed between the third surface 320A and the fourth surface 320B, a seventh side surface 320E facing the third lateral direction (e.g., the + X direction) crossing the first lateral direction and disposed between the third surface 320A and the fourth surface 320B, and an eighth side surface 320F facing the fourth lateral direction (e.g., the -X direction) that is opposite to the third lateral direction and disposed between the third surface 320A and the fourth surface 320B. In an embodiment, the second housing 320 may include a second plate 321 and a second side frame 322 that substantially extends in a thickness direction (e.g., a z-axis direction) along an edge of the second plate 321. In an embodiment, the second plate 321 may form the fourth surface 320B, and the second side frame 322 may form the fifth side surface 320C, the sixth side surface 320D, the seventh side surface 320E, and the eighth side surface 320F. In an embodiment, the second plate 321 and the second side frame 322 may be integrally formed or may be separately formed to be coupled to each other.

In an embodiment, the first housing 310 and the second housing 320 may form a front surface (e.g., a surface facing a +Z direction) of the electronic device 301 through the first surface 310A and the third surface 320A and may form a rear surface (e.g., a surface facing a -Z direction) of the electronic device 301 through the second surface 310B and the fourth surface 320B. In an embodiment, the second housing 320 may include an open portion 320G in which at least a portion of the fifth side surface 320C is open such that the first housing 310 may be partially movably inserted. However, this is an example, and in another embodiment, the first housing 310 may include an open portion in which at least a portion of the second side surface 310D is open, and the second housing 320 may be partially and movably inserted into the first housing 310 through the open portion formed in the second side surface 310D.

In an embodiment, the electronic device 301 may include a display 361 (e.g., a flexible display or a rollable display) for displaying visual information. In an embodiment, the display 361 may be exposed to the outside of the electronic device 301 through a display area 3610. In an embodiment, the display area 3610 may include a first area 361A provided parallel to the first surface 310A and the third surface 320A, a second area 361B connected to one end of the first area 361A, and a third area 361C connected to the other end of the first area 361A. The second area 361B and the third area 361C may be provided on opposite sides based on the first area 361A. In an embodiment, each of the second area 361B and the third area 361C may form a flexibly curved surface. In an embodiment, the display 361 may display a screen through the display area 3610. The display 361 may display one connected screen through the whole display area 3610 and may display a screen through a portion of the display area 3610. In another embodiment, the display 361 may display screens that are partially divided through the display area 3610. For example, the display 361 may display one screen through the first area 361A and may display another screen, which is different from the screen displayed through the first area 361A, through the second area 361B and/or the third area 361C.

In an embodiment, the display 361 may include a flat portion 3611 forming at least a portion of the display area 3610 and a rolling portion 3612 (or a bending portion) extending from the flat portion 3611. The rolling portion 3612 may be withdrawn from the inside to the outside of the electronic device 301 or may be inserted into the inside from the outside of the electronic device 301 according to the movement of the first housing 310 relative to the second housing 320. The rolling portion 3612 that is withdrawn to the outside of the electronic device 301 may be exposed to the outside of the electronic device 301 and may form the display area 3610 with the flat portion 3611. The area of the display area 3610 may change according to the degree of withdrawal of the rolling portion 3612.

In an embodiment, the area of the display area 3610 (e.g., the first area 361A, the second area 361B, and the third area 361C) of the display 361 may change according to a change in a state of the electronic device 301. In an embodiment, the display area 3610 of the display 361 may form a first area (e.g., a minimum area) reduced to the minimum in the first state (e.g., the reduced state or the shape of FIG. 3A) of the electronic device 301 and may form a second area (e.g., a maximum area) extended to the maximum in the second state (e.g., the extended state or the shape of FIG. 3C) of the electronic device 301. When the electronic device 301 is between the first state and the second state, the display 361 may expand or reduce the area of the display area 3610, corresponding to the state of the electronic device 301. For example, while changing from the first state to the second state, when the first housing 310 moves relative to the second housing 320 in the first moving direction (direction ①) by a certain length d, the length of the display area 3610 that is parallel to the first moving direction (direction ①) changes to a second length d2 increasing by the certain length d from a first length d1 such that the display area 3610 may be extended. Likewise, while changing from the second state to the first state, when the first housing 310 moves relative to the second housing 320 in the second moving direction (direction ②) by the certain length d, the length of the display area 3610 that is parallel to the second moving direction (direction ②) changes to the first length d1 decreasing by the certain length d from the second length d2 such that the display area 3610 may be reduced.

In an embodiment, the electronic device 301 may include at least one of an input module (e.g., the input module 150 of FIG. 1), a sound output module (e.g., the sound output module 155 of FIG. 1), a camera module 380 (e.g., the camera module 180 of FIG. 1), and a connector port 308.

In an embodiment, the input module may receive an input signal according to the manipulation of a user. The input module may be disposed on, for example, the seventh side surface 320E or the eighth side surface 320F of the second housing 320. However, the positions of the input module are not limited thereto. For example, the input module may also be disposed in the first housing 310.

In an embodiment, at least one housing between the first housing 310 and the second housing 320 may include a hole for radiating sound generated by the sound output module to the outside. For example, the first housing 310 may include a first hole H1 that is covered by the second housing 320 when the electronic device is in the first state and that is exposed to the outside when the electronic device is in the second state. For example, the second housing 320 may include a second hole H2 formed in at least one of the sixth side surface 320D, the seventh side surface 320E, and the eighth side surface 320F. For example, the first hole H1 and the second hole H2 may be substantially aligned with each other when the electronic device 301 is in the first state.

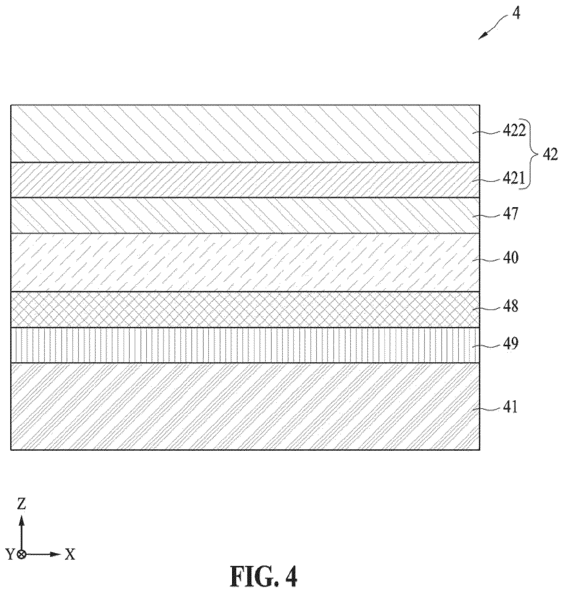

FIG. 4 is a cross-sectional view illustrating an electronic device according to an embodiment.

Referring to FIG. 4, an electronic device 4 (e.g., the electronic device 101 of FIG. 1, the electronic device 201 of FIG. 2A, and the electronic device 301 of FIG. 3A) may include a deformable structure. The electronic device 4 may include a plurality of components stacked in a z-axis direction. The electronic device 4 may include a display 40, a metal plate 41, glass 42, a plurality of adhesive layers 47 and 48, and a panel 49.

The display 40 (e.g., the display 261 of FIG. 2A and the display 361 of FIG. 3A) may be deformable. When the electronic device 4 is a foldable electronic device, the display 40 may be provided in a foldable form. When the electronic device 4 is a rollable electronic device, the display 40 may be provided in a rollable form. For example, the display 40 may be an unbreakable (UB) panel. For example, the display 40 may have a thickness of 50 micrometers (µm) to 150 µm. For example, the thickness of the display 40 may be 100 µm. However, the material and thickness of the display 40 are not limited thereto.

The metal plate 41 may support the display 40. The metal plate 41 may have a more rigid material than the display 40. The metal plate 41 may assist the display 40 to be stably deformed. The metal plate 41 may support the display 40 to prevent the display 40 from being unintentionally deformed. The metal plate 41 may have a lattice pattern. Here, the lattice pattern may refer to a pattern including a plurality of slits and a plurality of bridges. The plurality of bridges may include a main bridge and a connection bridge formed in different directions. However, the lattice pattern may have various shapes and is not limited to the embodiments described herein. For example, the metal plate 41 may have a thickness of 120 µm to 2,200 µm. For example, the thickness of the metal plate 41 may be 170 µm. The metal plate 41 may have a rigid material than the display 40. The metal plate 41 may be made of, for example, a metal material.

The glass 42 may cover the display 40. The glass 42 may include a glass body 421 and a protective layer 422 configured to cover the glass body 421. For example, the glass body 421 may have a thickness of 10 µm to 50 µm. For example, the thickness of the glass body 421 may be 30 µm. The glass body 421 may be ultra-thin glass (UTG). For example, the protective layer 422 may have a thickness of 50 µm to 150 µm. For example, the thickness of the protective layer 422 may be 100 µm.

The plurality of adhesive layers 47 and 48 may include a first adhesive layer 47 connecting the display 40 to the glass 42 and a second adhesive layer 48 connecting the display 40 to the panel 49. The first adhesive layer 47 and the second adhesive layer 48 may include a pressure sensitive adhesive (PSA). The first adhesive layer 47 may have a thickness of 20 µm to 80 µm. For example, the thickness of the first adhesive layer 47 may be 50 µm. The second adhesive layer 48 may have a thickness of 5 µm to 35 µm. For example, the thickness of the second adhesive layer 48 may be 20 µm.

The panel 49 may be provided between the metal plate 41 and the second adhesive layer 48. For example, the panel 49 may be a C-panel.

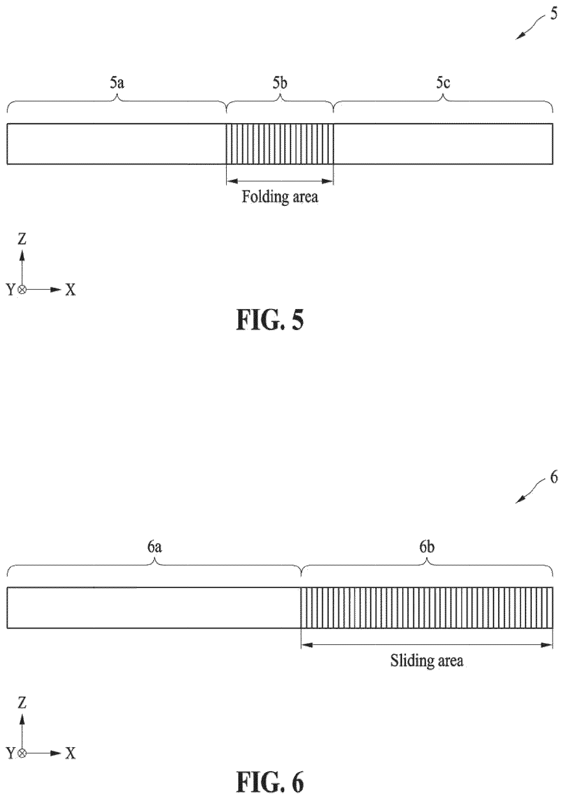

FIG. 5 is a side view schematically illustrating a foldable electronic device according to an embodiment.

Referring to FIG. 5, an electronic device 5 (e.g., the electronic device 101 of FIG. 1 and the electronic device 201 of FIG. 2A) may be foldable. For example, the electronic device 5 may include a pair of unfolding areas 5a and 5c, which are provided to be spaced apart from each other in an x-axis direction, and a folding area 5b provided between the pair of unfolding areas 5a and 5c. The electronic device 5 may have a lattice pattern formed in the folding area 5b. The lattice pattern may assist the electronic device 5 to be folded or to be unfolded more easily. The lattice pattern may reduce the rigidity of the folding area 5b. The folding area 5b may be more flexible than the unfolding areas 5a and 5c.

For example, a folding axis may be provided in the central portion of the folding area 5b. As a thickness of the folding area 5b moves away from the folding axis, the thickness or width of the lattice pattern may vary. For example, in a portion of the folding area 5b in which the folding axis is provided, the thickness of the folding area 5b may be relatively thinner. For example, as the folding area 5b moves away from the folding axis, the thickness of the folding area 5b may become relatively thicker.

FIG. 6 is a side view schematically illustrating a rollable electronic device according to an embodiment.

Referring to FIG. 6, an electronic device 6 (e.g., the electronic device 101 of FIG. 1 and the electronic device 301 of FIG. 3A) may be rollable. For example, the electronic device 6 may include a flat area 6a and a sliding area 6b, which are parallel to an x-axis direction. The electronic device 6 may have a lattice pattern formed in the sliding area 6b. The lattice pattern may assist a portion of the electronic device 6 in which the sliding area 6b is formed to be easily deformed. The lattice pattern may reduce the rigidity of the sliding area 6b. The sliding area 6b may be more flexible than the flat area 6a.

As a thickness of the sliding area 6b moves away from the flat area 6a, the thickness or width of the lattice pattern may vary. For example, as the sliding area 6b approaches the flat area 6a of the sliding area 6b, the thickness of the sliding area 6b may be relatively thicker. For example, as the sliding area 6b moves away from the flat area 6a of the sliding area 6b, the thickness of the sliding area 6b may become relatively thinner.

Hereinafter, the lattice pattern is described based on being formed in a rollable electronic device, but the lattice pattern may be equally applied to a foldable electronic device.

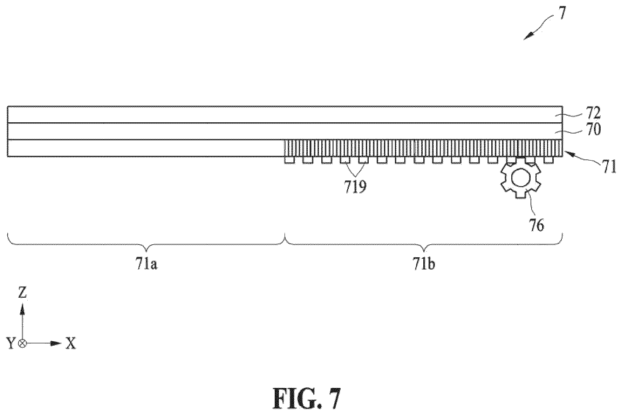

FIG. 7 is a side view schematically illustrating a rollable electronic device according to an embodiment.

Referring to FIG. 7, an electronic device 7 (e.g., the electronic device 101 of FIG. 1 and the electronic device 301 of FIG. 3A) may be rollable. The electronic device 7 may include a display 70 (e.g., the display 40 of FIG. 4), a metal plate 71, glass 72 (e.g., the glass 42 of FIG. 4), and a rolling gear 76. Hereinafter, the description is provided based on an embodiment in which the electronic device 7 includes the rolling gear 76 but it is not limited thereto. For example, the electronic device 7 may not include the rolling gear 76. For example, a user may directly roll the electronic device 7 using their hands.

The metal plate 71 may include a flat area 71a and a sliding area 71b. The lattice pattern may not be provided in the flat area 71a. The lattice pattern may be provided in the sliding area 71b. The lattice pattern may include a plurality of slits and a plurality of bridges. For example, the plurality of bridges may include a main bridge of which a longitudinal direction is formed in a direction that is parallel to a y-axis direction, and a connection bridge connecting two adjacent main bridges and of which a longitudinal direction is formed in a direction that is parallel to an x-axis direction. However, the shapes of the main bridge and the connection bridge are not limited thereto.

The metal plate 71 may include a plurality of multi-bars 719. A longitudinal direction of each of the plurality of multi-bars 719 may be formed parallel to the y-axis direction. The plurality of multi-bars 719 may be arranged side by side in the x-axis direction. For example, the plurality of multi-bars 719 may be arranged at equal intervals from each other.

The rolling gear 76 may be engaged with the plurality of multi-bars 719. The rolling gear 76 may rotate about a rotation axis that is parallel to a y-axis. The rolling gear 76 may rotate in a clockwise direction or a counterclockwise direction. For example, when the rolling gear 76 rotates in a clockwise direction, the metal plate 71 may be wound in engagement with the rolling gear 76. For example, when the rolling gear 76 rotates in a counterclockwise direction, the metal plate 71 may be unwound in engagement with the rolling gear 76.

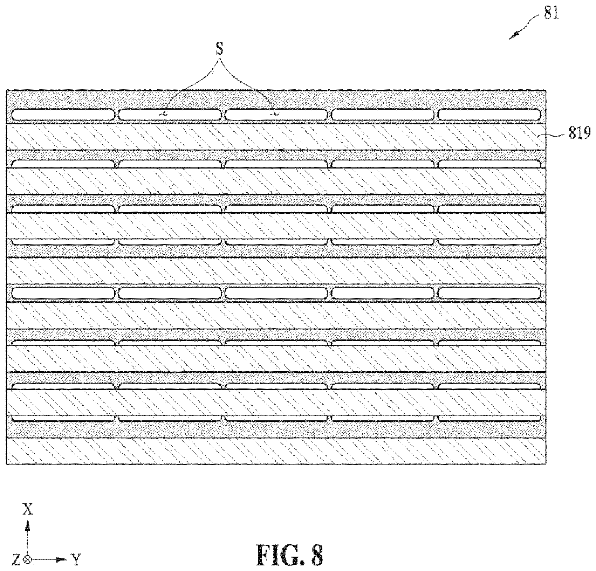

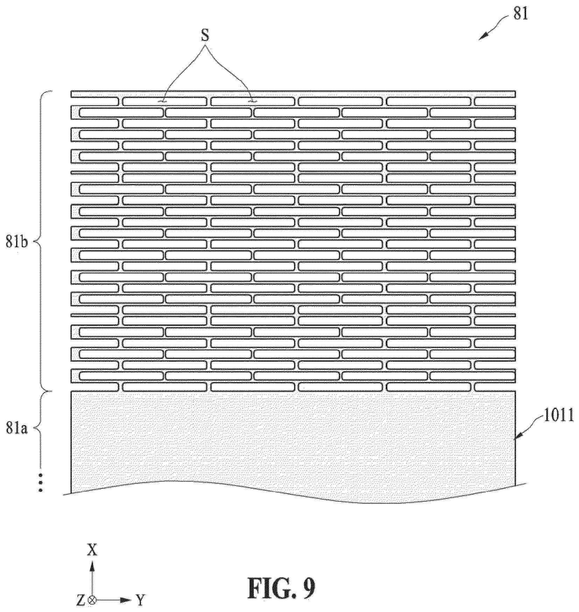

FIG. 8 is a bottom view illustrating a metal plate according to an embodiment, and FIG. 9 is a bottom view illustrating a state in which a multi-bar is removed from a metal plate, according to an embodiment.

Referring to FIGS. 8 and 9, a metal plate 81 may have a lattice pattern. The metal plate 81 may include a flat area 81a and a sliding area 81b. The lattice pattern may be provided in the sliding area 81b. The lattice pattern may include a plurality of slits S and a plurality of bridges defined by the plurality of slits S. The metal plate 81 may include a plurality of multi-bars 819 connected to the plurality of bridges.

The plurality of slits S may be formed through the metal plate 81 in a z-axis direction. The plurality of slits S may be provided in plurality in parallel along an x-axis direction and a y-axis direction. A main bridge of which a longitudinal direction is formed in the y-axis direction may be provided between two adjacent slits of the plurality of slits S arranged in the x-axis direction. A connection bridge of which a longitudinal direction is formed in the x-axis direction may be provided between two adjacent slits of the plurality of slits S arranged in the y-axis direction. The connection bridge may connect main bridges that are spaced apart from each other. In this specification, a portion of the metal plate 81 referred to as a metal plate body 1011 may refer to a smooth plate portion 81a in which the slits S are not formed. It should be noted that in the metal plate 81, a portion 81b in which the slits S are formed so that the plurality of bridges is formed is not referred to as the metal plate body 1011 but is referred to as a plurality of bridges and a plurality of slits.

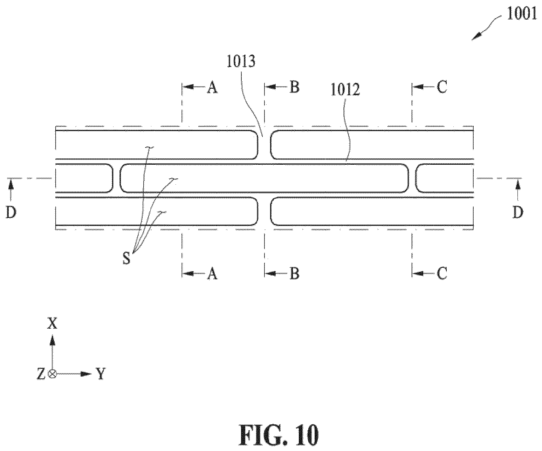

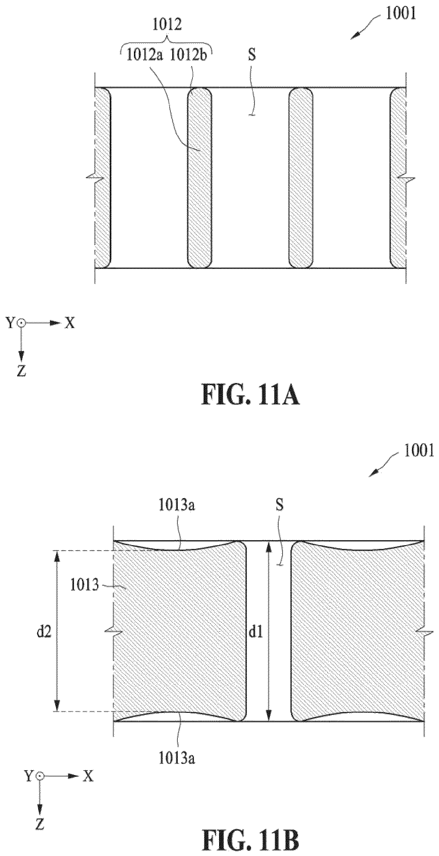

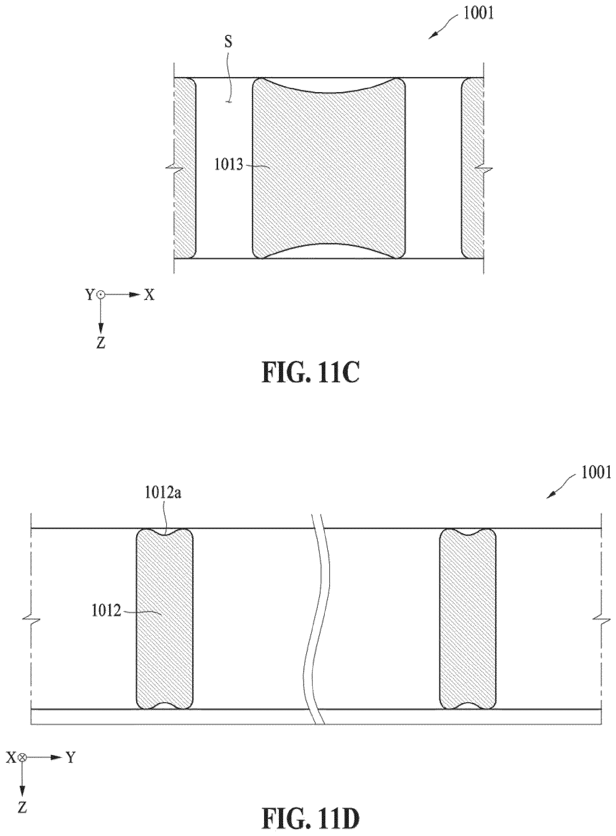

FIG. 10 is an enlarged bottom view illustrating a portion of a metal plate, according to an embodiment. FIG. 11A is a cross-sectional view taken along the line A-A of FIG. 10, FIG. 11B is a cross-sectional view taken along the line B-B of FIG. 10, FIG. 11C is a cross-sectional view taken along the line C-C of FIG. 10, and FIG. 11D is a cross-sectional view taken along the line D-D of FIG. 10.

Referring to FIGS. 10, 11A, 11B, 11C, and 11D, a metal plate 1001 (e.g., the metal plate 71 of FIG. 7 and the metal plate 81 of FIG. 8) may include the metal plate body 1011 (see FIG. 9), a plurality of slits S, a plurality of main bridges 1012, and a plurality of connection bridges 1013.

The metal plate body 1011 may support glass (e.g., the glass 42 of FIG. 4). The metal plate body 1011 may have a flat plate shape. The metal plate body 1011 may have a thickness in a z-axis direction. A thickness of the metal plate body 1011 may be constant on an xy plane.

In this specification, a portion of the metal plate 1001 referred to as the metal plate body 1011 (see FIG. 9) may refer to a smooth plate portion in which the slits S are not formed. It should be noted that in the metal plate 1001, the portion 81b in which the slits S are formed so that the plurality of bridges is formed is not referred to as the metal plate body 1011 but is referred to as a plurality of bridges and a plurality of slits.

The plurality of slits S may be formed through the metal plate 1001. The plurality of slits S may be formed through the metal plate 1001 in the z-axis direction. The plurality of slits S may be provided in plurality on the xy plane. The plurality of slits S may be provided in plurality in an x-axis direction and provided in plurality in a y-axis direction. Bridges 1012 and 1013 may be defined between adjacent slits of the plurality of slits S. The bridges 1012 and 1013 may refer to, for example, a portion of the metal plate 1001 except for the slits S. For example, the bridges 1012 and 1013 are provided in a portion of the overall metal plate 1001 in which the slits S are formed, and may refer to a portion defined by the slits S. It may be understood that the bridges 1012 and 1013 are provided in a portion of the metal plate 1001 in which the slits S are formed, and the metal plate body 1011 is provided in a portion of the metal plate 1001 in which the slits S are not formed. A longitudinal direction of a plurality of main bridges 1012 may be formed in a first direction. Here, the first direction may refer to a direction that is parallel to a y-axis in the drawing. The plurality of main bridges 1012 may be arranged side by side in a second direction. Here, the second direction may refer to a direction that is parallel to an x-axis in the drawing. A longitudinal direction of each of the plurality of main bridges 1012 may be formed in the y-axis direction. Two adjacent main bridges 1012 of the plurality of main bridges 1012 may be provided to be spaced apart from each other in the x-axis direction. A slot S may be provided between the two adjacent main bridges 1012.

A longitudinal direction of a plurality of connection bridges 1013 may be formed in the second direction. The plurality of connection bridges 1013 may be arranged side by side in the first direction. A longitudinal direction of each of the plurality of connection bridges 1013 may be formed in the x-axis direction. Two adjacent connection bridges of the plurality of connection bridges 1013 may be provided to be spaced apart from each other in the y-axis direction. The slot S may be provided between the two adjacent connection bridges 1013. The plurality of connection bridges 1013 may connect two adjacent main bridges 1012. For example, any one slot S may be surrounded by the two main bridges 1012 and the two connection bridges 1013.

The plurality of main bridges 1012 may include a main bridge body 1012a formed in the z-axis direction, which is a thickness direction of the metal plate 1001, and a main bridgehead 1012b formed at an edge portion of the main bridge body 1012a. For example, an area of an opening portion of the plurality of slits S may be larger than an area of the central portion in the thickness direction of the metal plate 1001.

The plurality of connection bridges 1013 may have a thickness that is thinner than the metal plate body 1011. For example, stress may concentrate on the plurality of connection bridges 1013 while the metal plate 1001 is deformed. By forming the thickness of the plurality of connection bridges 1013 to be thinner than the metal plate body 1011, a degree on which stress is concentrated may be reduced, and the repulsion force generated during deformation may be reduced.

The connection bridges 1013 may include a portion of which a thickness changes along the second direction. The connection bridges 1013 may include a portion of which a thickness changes along the x-axis direction. For example, the connection bridges 1013 may have a shape of which a thickness gradually decreases and then increases along the x-axis direction. For example, the connection bridges 1013 may have the smallest thickness in the central portion. For example, the thickness of the metal plate body 1011 may be a first thickness d1, and the minimum thickness of the connection bridges 1013 may be a second thickness d2 that is thinner than the first thickness d1. The maximum thickness of the connection bridges 1013 may be provided at both end portions based on the x-axis direction. The maximum thickness of the connection bridges 1013 may be less than or equal to the first thickness d1.

The connection bridges 1013 may include a bridge groove 1013a that is recessed from one surface. For example, the connection bridges 1013 may have the bridge groove 1013a in each of upper and lower surfaces. Here, the lower surface may refer to a surface facing a +z direction, and the upper surface may refer to a surface facing a -z direction. The bridge groove 1013a may have a curved shape.

The connection bridges 1013 may include a portion of which a thickness changes along the first direction. The connection bridges 1013 may include a portion of which a thickness changes along the y-axis direction. For example, the connection bridges 1013 may have a shape of which a thickness gradually decreases and then increases along the y-axis direction. For example, the connection bridges 1013 may have the smallest thickness in the central portion.

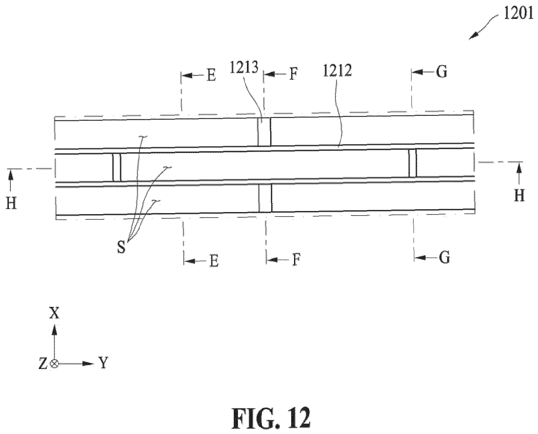

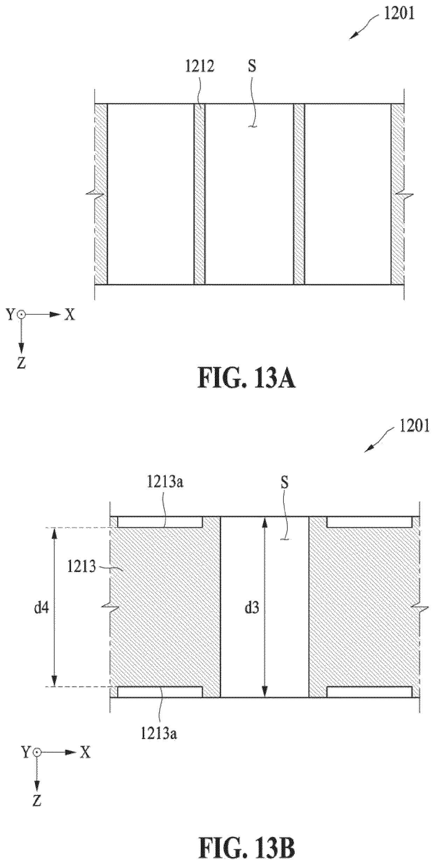

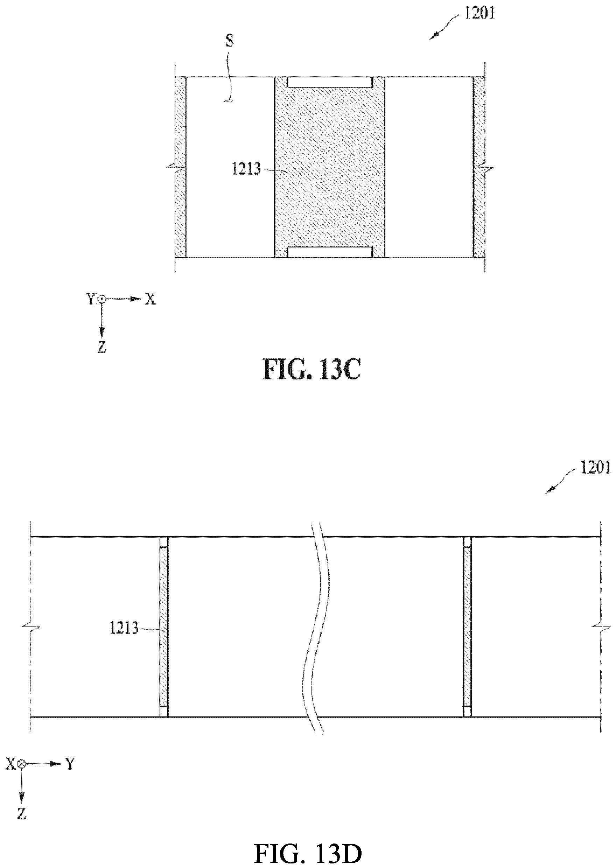

FIG. 12 is an enlarged bottom view illustrating a portion of a metal plate, according to an embodiment. FIG. 13A is a cross-sectional view taken along the line E-E of FIG. 12, FIG. 13B is a cross-sectional view taken along the line F-F of FIG. 12, FIG. 13C is a cross-sectional view taken along the line G-G of FIG. 12, and FIG. 13D is a cross-sectional view taken along the line H-H of FIG. 12.

Referring to FIGS. 12, 13A, 13B, 13C, and 13D, a metal plate 1201 (e.g., the metal plate 71 of FIG. 7 and the metal plate 81 of FIG. 8) may include a plurality of slits S, a plurality of main bridges 1212, and a plurality of connection bridges 1213.

The plurality of slits S may be formed through the metal plate 1201. The plurality of slits S may be formed through the metal plate 1201 in a z-axis direction. The plurality of slits S may be provided in plurality on an xy plane. The plurality of slits S may be provided in plurality in an x-axis direction and provided in plurality in a y-axis direction. Bridges 1212 and 1213 may be defined between adjacent slits of the plurality of slits S. The bridges 1212 and 1213 may refer to, for example, a portion of the metal plate except for the slits S.

The plurality of connection bridges 1213 may have a thickness that is thinner than the metal plate body 1011 (see FIG. 9). For example, stress may concentrate on the plurality of connection bridges 1213 while the metal plate 1201 is deformed. By forming the thickness of the plurality of connection bridges 1213 to be thinner than the metal plate body 1011, a degree on which stress is concentrated may be reduced, and the repulsion force generated during deformation may be reduced.

The connection bridges 1213 may include a portion of which a thickness changes along a second direction. The connection bridges 1213 may include a portion of which a thickness changes along the x-axis direction. For example, the connection bridges 1213 may have a step 1213a. A portion of the connection bridges 1213 in which the step 1213a is formed may have a thickness that is relatively thinner than other portions. For example, the thickness of the metal plate body 1011 may be a third thickness d3, and the minimum thickness of the connection bridges 1213 may be a fourth thickness d4 that is thinner than the third thickness d3. The maximum thickness of the connection bridges 1213 may be provided at both end portions based on the x-axis direction. The maximum thickness of the connection bridge 1213 may be less than or equal to the third thickness d3.

According to an embodiment, an electronic device may include a display, glass configured to cover the display, and a metal plate provided on an opposite side of the glass with respect to the display and configured to support the display, in which the metal plate may include a plurality of slits formed through the metal plate, a plurality of main bridges defined by the plurality of slits and of which a longitudinal direction is formed in a first direction, and a plurality of connection bridges defined by the plurality of slits, connected to the plurality of main bridges, of which a longitudinal direction is formed in a second direction crossing the first direction, and having a thickness that is thinner than a metal plate body.

In an embodiment, the plurality of main bridges may be arranged side by side in the second direction, and the plurality of connection bridges may be arranged side by side in the first direction.

In an embodiment, the connection bridges may include a portion of which a thickness changes along the second direction.

In an embodiment, the connection bridges may include a portion of which a thickness becomes thinner and then thicker along the second direction.

In an embodiment, the connection bridges may have a bridge groove that is recessed from one surface.

In an embodiment, the bridge groove may have a curved shape.

In an embodiment, the connection bridges may have a step.

In an embodiment, the connection bridges may include a portion of which a thickness becomes thicker and then thinner along the second direction.

In an embodiment, the connection bridges may include a bridge protrusion protruding in a third direction crossing the first direction and the second direction.

In an embodiment, the bridge protrusion may have a curved shape.

In an embodiment, the thickness of the connection bridges may be thinner than a thickness of the metal plate body in a portion in which the bridge protrusion is provided.

In an embodiment, the connection bridges may include a portion of which a thickness changes along the first direction.

In an embodiment, the connection bridges may include a portion of which a thickness becomes thinner and then thicker along the first direction.

In an embodiment, the main bridges may include a main bridge body and a main bridgehead formed in an edge portion of the main bridge body.

In an embodiment, the metal plate may further include a plurality of multi-bars attached to the metal plate.

According to an embodiment, a metal plate may include a metal plate body, a plurality of slits formed through the metal plate, a plurality of main bridges defined by the plurality of slits and of which a longitudinal direction is formed in a first direction, and a plurality of connection bridges defined by the plurality of slits, connected to the plurality of main bridges, of which a longitudinal direction is formed in a second direction crossing the first direction, and having a thickness that is thinner than the metal plate body.

In an embodiment, the connection bridges may include a portion of which a thickness changes along the second direction.

In an embodiment, the connection bridges may include a portion of which a thickness becomes thinner and then thicker along the second direction.

In an embodiment, the connection bridges may have a step.

According to an embodiment, an electronic device may include a display, glass configured to cover the display, a metal plate provided on an opposite side of the glass with respect to the display and configured to support the display, in which the metal plate may include a plurality of slits formed through the metal plate, a plurality of main bridges defined by the plurality of slits and of which a longitudinal direction is formed in a first direction, and a plurality of connection bridges defined by the plurality of slits, connected to the plurality of main bridges, and of which a longitudinal direction is formed in a second direction crossing the first direction, and a plurality of multi-bars attached to the metal plate, in which the connection bridges may include a portion of which a thickness changes along the second direction.

## Claims

1. An electronic device comprising:
a display;
glass configured to cover the display; and
a metal plate provided on an opposite side of the glass with respect to the display and configured to support the display,
wherein the metal plate comprises a plurality of slits formed through the metal plate, a plurality of main bridges defined by the plurality of slits and of which a longitudinal direction is formed in a first direction, and a plurality of connection bridges defined by the plurality of slits, connected to the plurality of main bridges, of which a longitudinal direction is formed in a second direction crossing the first direction, and having a thickness that is thinner than a metal plate body.

2. The electronic device of claim 1, wherein
the plurality of main bridges is arranged side by side in the second direction,
the plurality of connection bridges is arranged side by side in the first direction.

3. The electronic device of claim 1, wherein the connection bridges comprise a portion of which a thickness changes along the second direction.

4. The electronic device of claim 1, wherein the connection bridges comprise a portion of which a thickness becomes thinner and then thicker along the second direction.

5. The electronic device of claim 4, wherein the connection bridges have a bridge groove that is recessed from one surface.

6. The electronic device of claim 5, wherein the bridge groove has a curved shape.

7. The electronic device of claim 1, wherein the connection bridges have a step.

8. The electronic device of claim 1, wherein the connection bridges comprise a portion of which a thickness becomes thicker and then thinner along the second direction.

9. The electronic device of claim 8, wherein the connection bridges comprise a bridge protrusion protruding in a third direction crossing the first direction and the second direction.

10. The electronic device of claim 9, wherein the bridge protrusion has a curved shape.

11. The electronic device of claim 9, wherein the thickness of the connection bridges is thinner than a thickness of the metal plate body in a portion in which the bridge protrusion is provided.

12. The electronic device of claim 9, wherein the connection bridges comprise a portion of which a thickness changes along the first direction.

13. The electronic device of claim 12, wherein the connection bridges comprise a portion of which a thickness becomes thinner and then thicker along the first direction.

14. The electronic device of claim 1, wherein the main bridges comprise a main bridge body and a main bridgehead formed in an edge portion of the main bridge body.

15. The electronic device of claim 1, wherein the metal plate further comprises a plurality of multi-bars attached to the metal plate.
